# EUROPEAN PATENT APPLICATION

(11) **EP 2 613 398 A1**
(43) Date of publication of application: **10.07.2013**
(21) Application number: 11821293.5
(22) Date of filing: 26.08.2011
(51) Int. Cl.: H01M 10/50, H01M 2/10

(54) **SHOVEL**

(30) Priority: 30.08.2010 JP 2010192051
(71) Applicant: Sumitomo Heavy Industries, Ltd., Tokyo 141-6025 (JP)
(72) Inventor: MIYATAKE, Tsutomu, Yokosuka-shi Kanagawa 237-0061 (JP); ADACHI, Shuntaro, Yokosuka-shi Kanagawa 237-0061 (JP)
(74) Representative: Wimmer, Hubert
(86) International application number: PCT/JP2011/004765
(87) International publication number: WO 2012/029270

(57) **Abstract**

An upper rotating body is rotatably mounted on a lower running body. A power storage module is mounted on the upper rotating body. The power storage module includes a plurality of power storage cells. Each of the plurality of power storage cells accumulates electric energy. A heat absorbing plate is disposed between the power storage cells. The heat absorbing plate is thermally coupled to the power storage cells, and a flow channel circulating cooling medium is formed in the inner portion of the heat absorbing plate. A cooling medium supply device makes the cooling medium flow into the flow channel formed in the inner portion of the heat absorbing plate.

## Description

### Technical Field

The present invention relates to a shovel on which a power storage module having a structure which cools a plurality of power storage cells is mounted.

### Background Art

A hybrid type automobile or a hybrid type working machine which uses a power storage cell such as a chargeable secondary battery or a capacitor has been developed. In order to secure a desired operating voltage, a plurality of power storage cells are connected to one another in series. Various configurations for dissipating heat to the outside are proposed, the heat being generated in the plurality of power storage cells which are closely-disposed.

### Prior Art Documents

### Patent Literature

[PTL 1]: Japanese Unexamined Patent Application Publication No. 8-111244
[PTL 2]: Japanese Unexamined Patent Application Publication No. 2003-133188

### Summary of Invention

### Technical Problem to be Solved by Invention

An upper rotating body of a shovel is supported to a lower running body through a rotary bearing. In this way, the upper rotating body is rotatably mounted on the lower running body via contact between metals. Moreover, in general, the shovel is operated outside. Thereby, large vibration during the running is directly transmitted to the upper rotating body.

If a cooling mechanism which cools a power storage module is configured of many parts, a risk in which a contact state between the parts is deteriorated is increased due to the vibration. If the contact state between parts is deteriorated, heat transfer efficiency is decreased. In order to increase vibration resistance of the power storage module, it is preferable to reduce the number of parts.

Moreover, the increase of the number of parts of the power storage module causes an increase in assembly costs or maintenance time. Furthermore, for a decrease in the assembly costs or the maintenance time, it is preferable to reduce the number of parts.

### Means for Solving Problem

According to an aspect of the present invention, there is provided a shovel including:
a lower running body;
an upper rotating body which is rotatably mounted on the lower running body; and
a power storage module which is mounted on the upper rotating body,
wherein the power storage module includes:
   a plurality of power storage cells in which each accumulates electric energy;
   a heating absorbing plate which is disposed between the power storage cells and is thermally connected to the power storage cell and in which a flow channel circulating cooling medium is formed in the inner portion; and
   a cooling medium supply device which flows the cooling medium into the flow channel formed in the inner portion of the heat absorbing plate.

### Advantageous Effects of Invention

The power storage cells can be effectively cooled by circulating the cooling medium to the heat absorbing plate which is disposed between the power storage cells. The number of parts which are interposed between the power storage cell and the cooling medium can be reduced by circulating the cooling medium to the inner portion of the heat absorbing plate.

### Brief Description of Drawings

FIGS. 1A and 1B are respectively a plan cross-sectional view and a cross-sectional view of a power storage module according to Embodiment 1.
FIG. 2 is a cross-sectional view of the power storage module according to Embodiment 1.
FIG. 3A is a perspective view showing a heat transmission plate before folding which is used in the power storage module according to Embodiment 1, and FIG. 3B is a perspective view showing a heat transmission plate after the folding.
FIG. 4A is a plan cross-sectional view of the heat transmission plate which is used in the power storage module according to Embodiment 1, and FIG. 4B is a plan cross-sectional view of a state where the heat transmission plate is expanded while inserting the power storage cells.
FIG. 5A and 5B are respectively plan cross-sectional views of the heat transmission plate and the power storage cell which are used in power storage modules according Modification 1 and Modification 2 of Embodiment 1.
FIGS. 6A and 6B are respectively plan cross-sectional views of power storage modules according to Modification 3 and Modification 4 of Embodiment 1.
FIG. 7 is a plan cross-sectional view of a power storage module according to Modification 5 of Embodiment 1.
FIG. 8A and 8B are respectively a plan cross-sectional view and a cross-sectional view of a power storage module according to Embodiment 2.
FIGS. 9A and 9B are respectively plan cross-sectional views of power storage modules according to Modification 1 and Modification 2 of Embodiment 2.
FIG. 10 is a plan cross-sectional view of a power storage module according to Embodiment 3.
FIG. 11 is a cross-sectional view of the power storage module according to Embodiment 3.
FIG. 12A is a plan view of a heat transmission plate and power storage cells which are used in a power storage module according to a Embodiment 4 and FIG. 12B is an exploded perspective view thereof.
FIG. 13 is a plan cross-sectional view of a heat transmission plate and power storage cells which are used in a power storage module according to Embodiment 5.
FIG. 14A is a plan cross-sectional view of a heat transmission plate and power storage cells which are used in a power storage module according to Embodiment 6 and FIG. 14B is an exploded perspective view thereof.
FIG. 15 is a plan cross-sectional view of a heat transmission plate and power storage cells which are used in a power storage module according to Modification of Embodiment 6.
FIG. 16 is a schematic plan view of a hybrid type shovel according to Embodiment 7.
FIG. 17 is a schematic side view of the hybrid type shovel according to Embodiment 7.
FIG. 18 is a schematic side view of the hybrid type shovel according to Modification 1 of Embodiment 7.
FIG. 19 is a block diagram of the hybrid type shovel according to Embodiment 7.
FIG. 20 is an equivalent circuit diagram of a power storage circuit of the hybrid type shovel according to Embodiment 7.
FIG. 21 is a block diagram of a hybrid type shovel according to Modification 2 of Embodiment 7.

### Description of Embodiments

If electric energy density which is stored in a power storage cell is high, a cooling mechanism which more effectively transmits heat generated in the power storage cell to the outside is required. In Embodiments described below, the heat generated in the power storage cell can be effectively transmitted to the outside.

### [Embodiment 1]

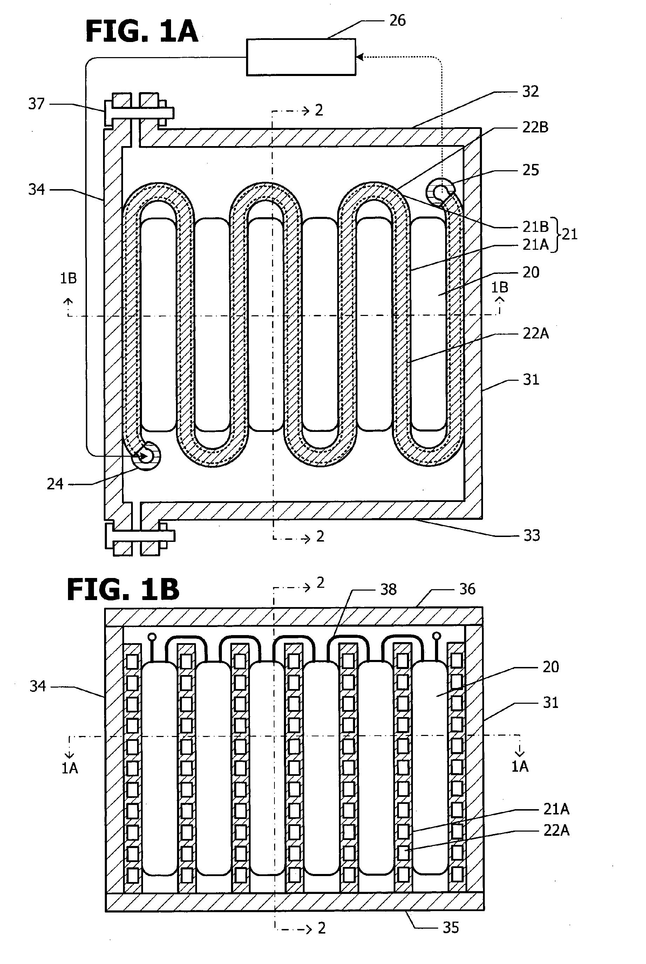

FIG. 1A shows a plan cross-sectional view of a power storage module according to Embodiment 1. A plurality of (at least four) plate-shaped power storage cells 20 are stacked (disposed) in the thickness direction. Each of the power storage cells 20 can accumulate electric energy and can discharge the accumulated electric energy. For example, as the power storage cell 20, an electric double layer capacitor in which collector electrodes, separators, electrolyte, and the like are sealed by a laminate film is used. Instead, a lithium ion capacitor, a lithium ion secondary battery, or the like which is sealed by a laminate film may be also used.

A heat absorbing plate 21A is disposed between two power storage cells 20 adjacent to each other. The heat absorbing plate 21A is thermally coupled to the power storage cells 20 on both sides of the heat absorbing plate 21A. Flow channels 22A are formed which circulates cooling mediums in a direction (a vertical direction in FIG. 1A) perpendicular to the stacked direction of the power storage cells 20 in the inner portion of the heat absorbing plate 21A.

One edge of one heat absorbing plate 21A is connected to the adjacent heat absorbing plate 21A by a connection member 21B, and the opposite edge thereof is connected to another adjacent heat absorbing plate 21A. Flow channels 22B are formed in the inner portion of the connection member 21B. The flow channels 22B are connected to the flow channels 22A in two heat absorbing plates 21A which are connected to the said connection member 21B. That is, the flow channels 22A in the heat absorbing plate 21A communicate with the flow channels 22A in the adjacent heat absorbing plate 21A via the flow channels 22B in the connection member 21B. The heat absorbing plates 21A and the connection members 21B are formed by folding a flat plate-shaped heat transmission plate 21 which is extrusion-molded so as to include the flow channels inside. The bent portions after the folding correspond to the connection members 21B and the flat plate-shaped portions correspond to the heat absorbing plates 21A. The folded heat transmission plate 21 includes the heat absorbing plates 21A and the connecting portions 21B, and forms a meandering shape (zigzag shape, serpentine shape). The configuration of the heat transmission plate 21 will be described in detail below.

The connection member 21B is connected to one edge of each of two heat absorbing plates 21A which are disposed in the outermost side, and the end portions of the flow channels 22A are opened to the other edge. A cooling medium introduction pipe 24 and a cooling medium discharging pipe 25 are respectively connected to the edges to which the flow channels 22A are opened. For example, the cooling medium introduction pipe 24 and the cooling medium discharging pipe 25 are soldered to the heat absorbing plate 21A.

A cooling medium, for example, cooling water, oil, chlorofluorocarbon, ammonia, hydrocarbon, air, or the like is introduced to the cooling medium introduction pipe 24 from a cooling medium supply device 26. The cooling medium which is introduced into the cooling medium introduction pipe 24 is transported to the cooling medium discharging pipe 25 via the flow channels 22A in the heat absorbing plates 21A and the flow channels 22B in the connection members 21B. The cooling medium which is transported to the cooling medium discharging pipe 25 is collected to the cooling medium supply device 26. For example, the cooling medium supply device 26 is comprised of a pump and a radiator.

A pair of end plates 31 and 34 and a pair of side plates 32 and 33 configure four wall surfaces among six wall surfaces of a parallelepiped structure. One end plate 31 and the pair of side plates 32 and 33 are formed by folding one plate. The end plates 31 and 34 are respectively disposed on ends in the stacked direction of the power storage cells 20. One end plate 34 is fixed to the side plates 32 and 33 using a fastener 37 which is comprised of a nut and a bolt. The fastener 37 applies a compressive force in the stacked direction to a stacked body in which the power storage cells 20 and the heat absorbing plates 21A are stacked. That is, the end plates 31 and 34, the side plates 32 and 33, and the fastener 37 serve as a pressurization mechanism which applies a compressive force to the stacked body.

The heat transmission plate 21 is supported between the end plate 31 and the end plate 34 in such posture that a generatrix of the bent surface of the connection member 21B is parallel to the side plates 32 and 33.

FIG. 1B is a cross-sectional view of a dashed-dotted line 1B-1B of FIG. 1A. The cross-sectional view of the dashed-dotted line 1A-1A of FIG. 1B corresponds to FIG. 1A. The power storage cells 20 and the heat absorbing plates 21A are alternately stacked. A plurality of flow channels 22A are formed in the inner portion of the heat absorbing plates 21A. In FIG. 1B, the cooling medium is transported in a direction perpendicular to the paper surface. A plurality of flow channels 22A are formed in the heat absorbing plates 21A, and the flow channels 22A are separated from each other by partitions. Since the partitions are formed, when the compressive force in the thickness direction is applied to the heat absorbing plate 21A, the heat absorbing plate 21A is not crushed, and the shape is maintained.

A bottom plate 35 and a top plate 36 constitute the case of the parallelepiped structure along with the side plates 32 and 33 (FIG. 1A) and the end plates 31 and 34. The heat absorbing plates 21A contact the bottom plate 35. The heat transmission plate 21 (FIG. 1A) is disposed in the case in such posture that a projection image perpendicular to a virtual plane of the parallelepiped structure corresponding to the bottom plate 35 exhibits a meandering shape. A gap is formed between the top plate 36 and the heat absorbing plate 21A. A plurality of power storage cells 20 are connected in series by wirings 38. The wirings 38 pass through the gap between the heat absorbing plate 21A and the top plate 36.

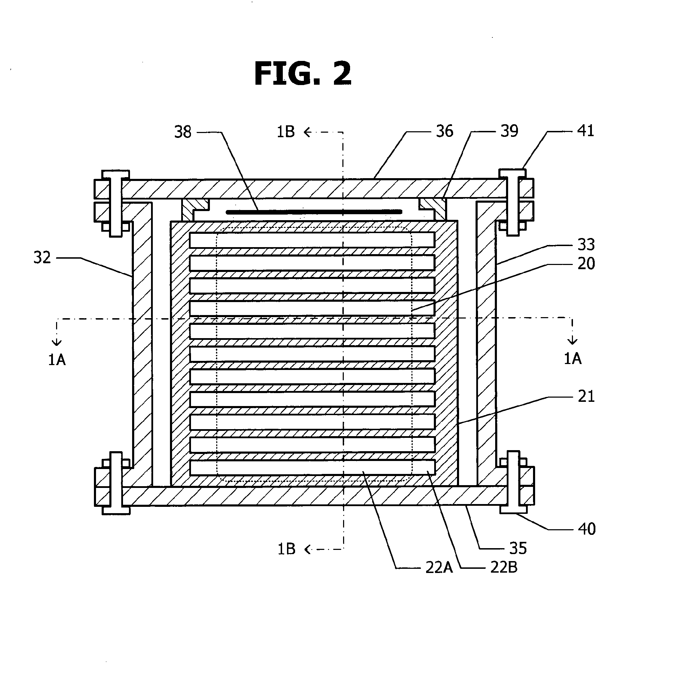

FIG. 2 is a cross-sectional view of a dashed-dotted line 2-2 of FIGS. 1A and 1B. The cross-sectional view of the dashed-dotted line 1A-1A of FIG. 2 corresponds to FIG. 1A, and the cross-sectional view of the dashed-dotted line 1B-1B corresponds to FIG. 1B.

The bottom plate 35 is fixed to the side plates 32 and 33 by a fastener 40 which is comprised of a bolt and a nut. The top plate 36 is fixed to the side plates 32 and 33 by a fastener 41 which is comprised of a bolt and a nut. Flow channels 22A and 22B are formed in the inner portion of the heat transmission plate 21. Two compressive force transmission members 39 are disposed in a gap between the heat transmission plate 21 and the top plate 36. For example, each of the compressive force transmission members 39 is a rod-shaped member having an L shaped cross-section and extends in the stacked direction of the power storage cells 20 (a direction perpendicular to the paper surface of FIG. 2). The compressive force transmission members 39 are fixed to the top plate 36 by welding or the like, and contacts the heat transmission plate 21. The compressive force in the direction perpendicular to the bottom plate 35 is applied to the heat transmission plate 21 via the compressive force transmission members 39 by the fasteners 40 and 41.

The compressive force restricts the position of the heat transmission plate 21 with respect to the direction perpendicular to the stacked direction of the power storage cells 20 in the case. The heat transmission plate 21 in which the position is restricted acts as a reinforcing rib which increase the mechanical strength of the case.

The compressive force transmission members 39 contact the heat transmission plate 21 in a position close to the side plates 32 and 33 rather than edges of the power storage cells 20 respectively facing the side plates 32 and 33. Thereby, influence of the compressive force operated in the direction perpendicular to the bottom plate 35 on the power storage cells 20 can be decreased.

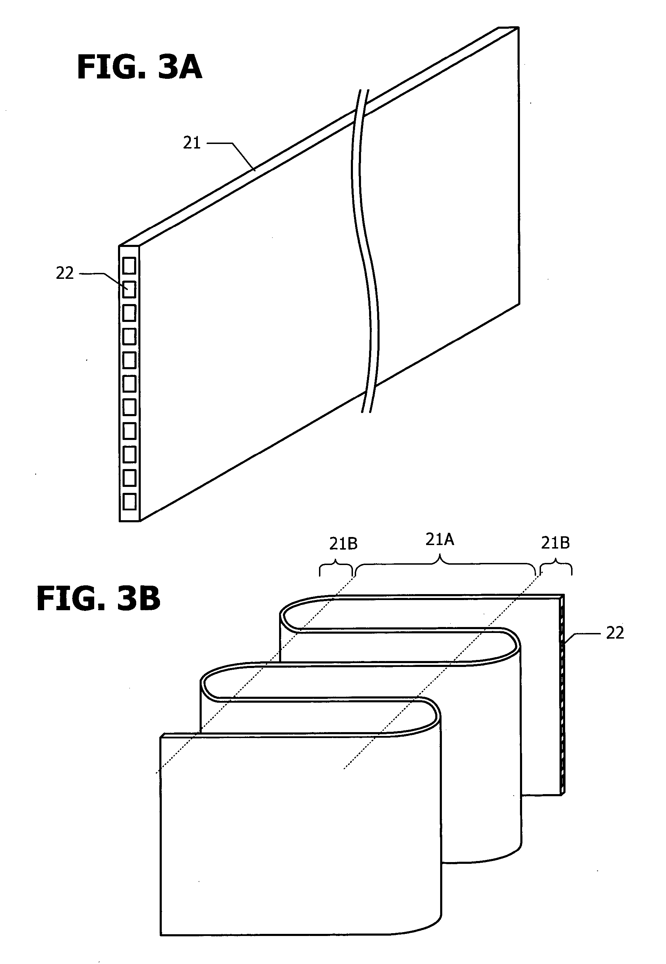

FIG. 3A is a perspective view of the heat transmission plate 21 before folding. The heat transmission plate 21 is a rectangular plate-shaped member and a plurality of flow channels 22 which extend in the longitudinal direction are formed in the inner portion of the heat transmission plate 21. Each of the flow channels 22 extends from one end surface perpendicular to the longitudinal direction of the heat transmission plate 21 to the opposite end surface. For example, a metal such as aluminum or the like is used for the heat transmission plate 21. The heat transmission plate 21 can be manufactured by extrusion-molding.

FIG. 3B is a perspective view of the heat transmission plate 21 after the folding. A flat plate-shaped heat transmission plate 21 is plastically deformed and exhibits a meandering shape. The bent portions correspond to the connection members 21B and the flat plate-shaped portions correspond to the heat absorbing plates 21A. Each of the flow channels 22 is meandered by folding the heat transmission plate 21.

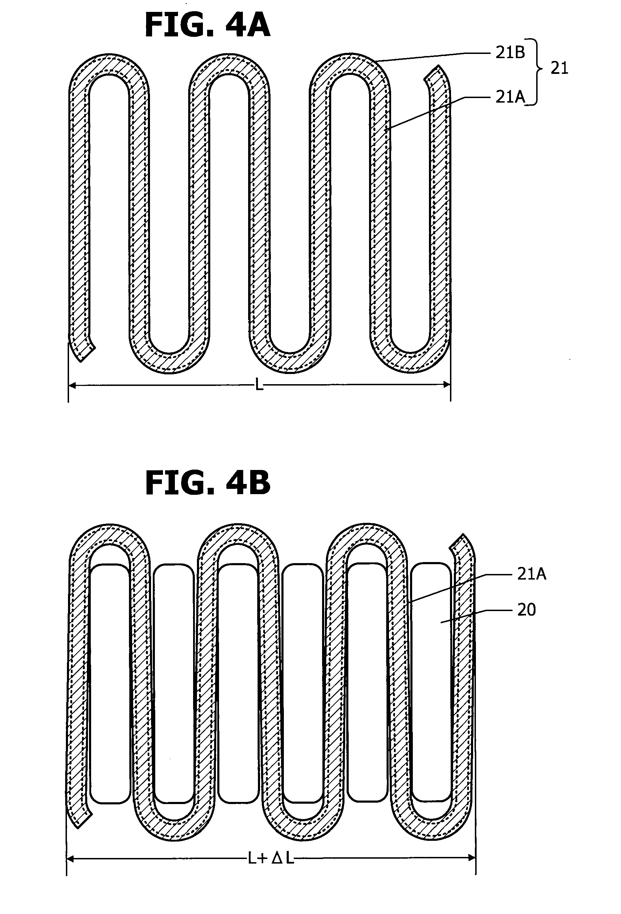

FIG. 4A is a plan cross-sectional view of the heat transmission plate 21 after the folding. The heat absorbing plates 21A which are the flat plate-shaped portions are disposed so as to be parallel to one another. That is, the bent angles of the bent portions are 180°. It may be considered that the heat transmission plate 21 after the folding is a spring having a natural length L. Here, the natural length L means the dimension of the heat transmission plate 21 in the stacked direction of the power storage cells 20 in a state where an external force is not applied to the heat transmission plate 21.

As shown in FIG. 4B, when placing the power storage cell 20 between the heat absorbing plates 21A, the spring comprised of the heat transmission plates 21 extends (heat transmission plates 21 are elastically deformed), and the gap between the heat absorbing plates 21A is slight widened. In this state, the power storage cell 20 is disposed between the heat absorbing plates 21A. If the force which extends the spring is released, since the power storage cells 20 are inserted between the heat absorbing plates 21A, the length of the spring does not return to the natural length L and becomes L + ΔL.

As shown in FIG. 1A, in the state where the compressive force is applied to the power storage cells 20 and the heat absorbing plates 21A, the dimension (the length of the spring) of the heat transmission plate 21 in the stacked direction of the power storage cells 20 becomes equal to the natural length L. Thereby, in the state where the compressive force is applied, the plurality of heat absorbing plates 21A are parallel to one another. Thereby, a substantially uniform pressure (approximately 0.5 MPa) in an in-plane direction can be applied to the power storage cell 20. Moreover, it is possible to prevent generation of a force in a direction which counteracts the compressive force.

Moreover, the heat transmission plate 21 may be plastically deformed so that the length of the heat transmission plate 21 in the state where the compressive force is applied is slightly longer than the natural length L. Also in this case, it is preferable that the heat absorbing plates 21A be plastically deformed so as to be parallel to one another in the state where the compressive force is applied. Specifically, the bent angle is slightly larger than 180°. In a state where the external force is not applied, the heat absorbing plates 21A are not parallel to one another. However, if the power storage cells 20 are inserted between the heat absorbing plates 21A and the compressive force is applied, the heat absorbing plates 21A become parallel to one another.

In the power storage module according to Embodiment 1, since the cooling medium passes between the power storage cells 20 and is discharged to the outside, it is possible to effectively cool the power storage cells 20. The flow channels 22A and 22B which meander for the cooling medium are formed by folding the flat plate-shaped heat transmission plate 21 which is manufactured by extrusion-molding. Thereby, compared to a case where a plurality of members are combined and manufactured, the manufacturing costs can be reduced.

Each of the power storage cells 20 includes the collector electrodes, the separators, and the electrolyte in the laminate film. If the power storage cell 20 is operated, gas is generated in the laminate film. If the generated gas is accumulated on the surface of the collector electrodes, electrical characteristics of the power storage cell 20 are decreased. In Embodiment 1, since the compressive force is applied to the power storage cell 20 by the pressurization mechanism comprised of the end plates 31 and 34 and the fastener 37, it is possible to exclude the generated gas from the surface of the collector electrodes. In this way, the compressive force due to the pressurization mechanism mechanically supports the power storage cell 20 and prevents electrical characteristics of the power storage cell 20 from being decreased.

When applying of the compressive force for maintaining the electrical characteristics is not needed in the power storage cell 20, for example, when a lithium ion capacitor or the like is used, the pressurization mechanism is not necessarily essential. For example, when the compressive force is not applied, the power storage cells 20 may be fixed to the heat absorbing plate 21A by coating adhesive to four corners of the power storage cell 20. For example, silicone based adhesive may be used as the adhesive. Thereby, vibration resistance, impact resistance, and heat transfer properties can be improved.

Moreover, it is preferable to dispose grease or a heat transfer sheet in an area where the adhesive is not applied. Heat transfer properties can be improved by disposing the grease or the heat transfer sheet.

When the compressive force is not applied, one flow channel having a large cross-sectional area may be formed in the heat transmission plate 21 without providing the partitions between the plurality of flow channels 22A or 22B. The pressure loss of the cooling medium can be decreased by increasing the cross-sectional area of the flow channel.

Furthermore, even when the power storage cells 20 are fixed by an adhesive, in order to increase the heat transfer efficiency from the power storage cells 20 to the heat absorbing plates 21A, a compressive force may be applied. The compressive force may be smaller than the compressive force for mechanically supporting the power storage cells 20. In this case, the length of the heat transmission plate 21 in the stacked direction of the power storage cells 20 is shorter than L + ΔL shown in FIG. 4B.

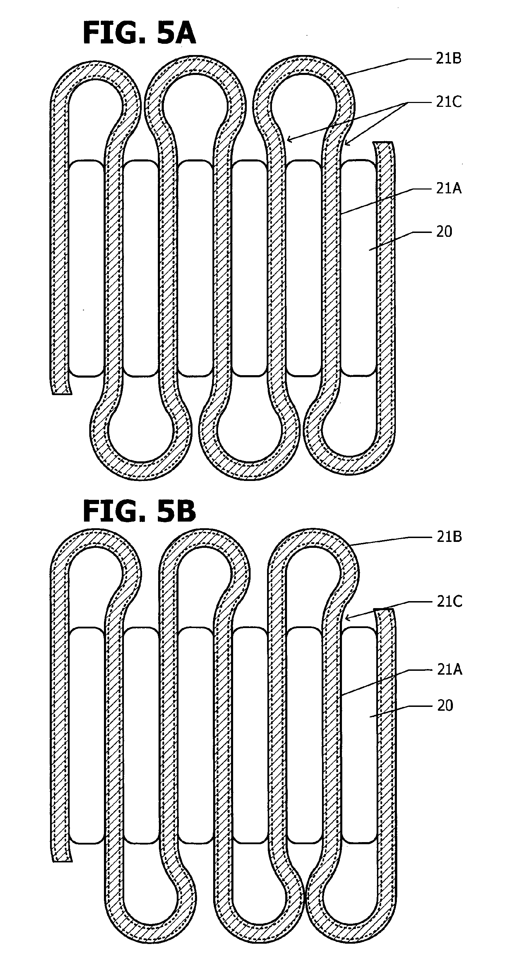

FIG. 5A is a plan cross-sectional view of the heat transmission plate 21 and the power storage cells 20 according to Modification 1 of Embodiment 1. For example, as shown in FIG. 1A, in Embodiment 1, each of the connection members 21B is bent only in one direction. That is, the bent outside surface of the connection member 21B is convex toward the outer side in any position. On the other hand, in Modification 1, in a connection portion 21C of the connection member 21B which is connected to the heat absorbing plate 21A, the connection member 21B is bent in a direction opposite to the direction in which the heat transmission plate 21 is to be bent. Thereby, the connection member 21B protrudes to further outside in the stacked direction of the power storage cells 20 than positions of the two heat absorbing plates 21A to which the connection member 21B is connected.

FIG. 5B shows a plan cross-sectional view of the heat transmission plate 21 and the power storage cells 20 according to Modification 2 of Embodiment 1. In Modification 2, in only one of connection portions 21C connected to the two heat absorbing plates 21A, the connection member 21B is bent in the direction opposite to the direction in which the heat transmission plate 21 is to be bent. Thereby, the connection member 21B protrudes to further outside in the stacked direction of the power storage cells 20 than the position of one of the two heat absorbing plates 21A to which the connection member 21B is connected.

In Modification 1 and Modification 2, the curvature radius of the bent portion of the heat transmission plate 21 can be larger than the curvature radius of the structure of Embodiment 1. Thereby, a decrease of material strength due to the plastic deformation can be suppressed. Moreover, the spring constant of the spring which is comprised of the heat transmission plate 21 is smaller than the case of Embodiment 1. Thereby, when placing the power storage cells 20 between the heat absorbing plates 21A, the heat transmission plate 21 can be easily deformed.

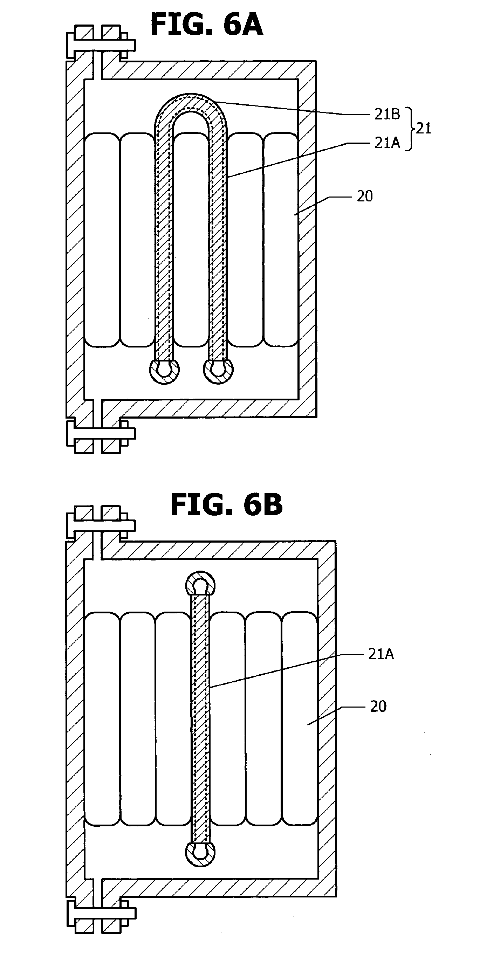

FIG. 6A is a plan cross-sectional view of the power storage module according to Modification 3 of Embodiment 1. In descriptions below, the descriptions with respect to the same configuration will be omitted with focusing on the differences from Embodiment 1. In Embodiment 1, the plan cross-section of the heat transmission plate 21 is the meandering shape. However, in Modification 3, the bent portion of the heat transmission plate 21 is only one location. The heat absorbing plates 21A are disposed in two locations among the power storage cells 20. Thereby, the plan cross-section of the heat transmission plate 21 has a U shape. The configuration of Modification 3 can be applied to a case where at least three power storage cells 20 are stacked.

FIG. 6B is a plan cross-sectional view of the power storage module according to Modification 4 of Embodiment 1. In descriptions below, the descriptions with respect to the same configuration will be omitted with focusing on the differences from Embodiment 1. In Modification 4, the heat transmission plate 21 is not bent, and the heat absorbing plate 21A is disposed in only one location between the power storage cells 20. The configuration of Modification 4 can be applied to a case where at least two power storage cells 20 are arranged.

In Modification 3 and Modification 4, similar to Embodiment 1, it is possible to effectively cool the power storage cells 20.

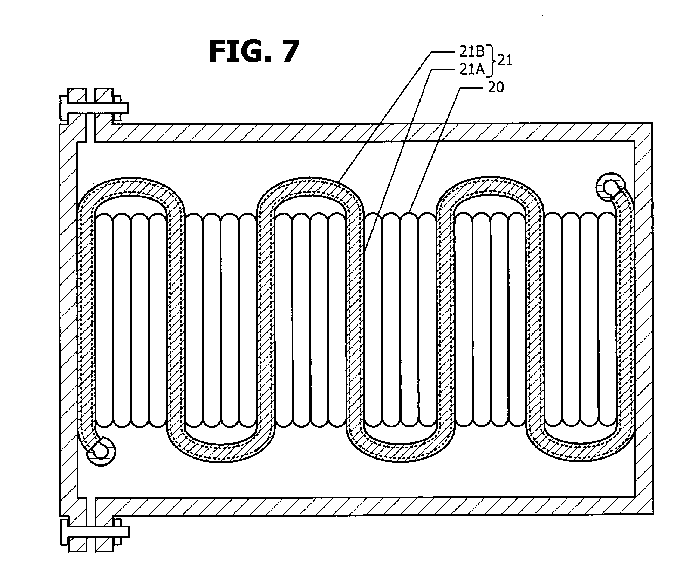

FIG. 7 is a plan cross-sectional view of the power storage module according to Modification 5 of Embodiment 1. In descriptions below, the descriptions with respect to the same configuration will be omitted with focusing on the differences from Embodiment 1. As shown in FIG. 1A, in Embodiment 1, the power storage cells 20 and the heat absorbing plates 21A are alternately stacked. That is, one power storage cell 20 is disposed between the heat absorbing plates 21A which are adjacent to each other. In Modification 5, a plurality of, for example, four power storage cells 20 are disposed between the heat absorbing plates 21A which are adjacent to each other.

Two power storage cells 20 which are positioned in the inner side among four power storage cells 20 do not directly contact the heat absorbing plate 21A. The heat which is generated in two power storage cells 20 of the inner side is transmitted to the heat absorbing plates 21A via the outer side power storage cells 20. Compared to Embodiment 1, in the power storage module according to Modification 5, the cooling performance of the power storage cell 20 is decreased. However, the dimension in the stacked direction of the power storage cells 20 is decreased, and thus, reduction in weight can be realized. It is preferable that the number of the power storage cells 20 which are disposed between the heat absorbing plates 21A be determined by a heating value and an allowable temperature upper limit of the power storage cell 20, and cooling performance of the heat transmission plate 21, or the like.

### [Embodiment 2]

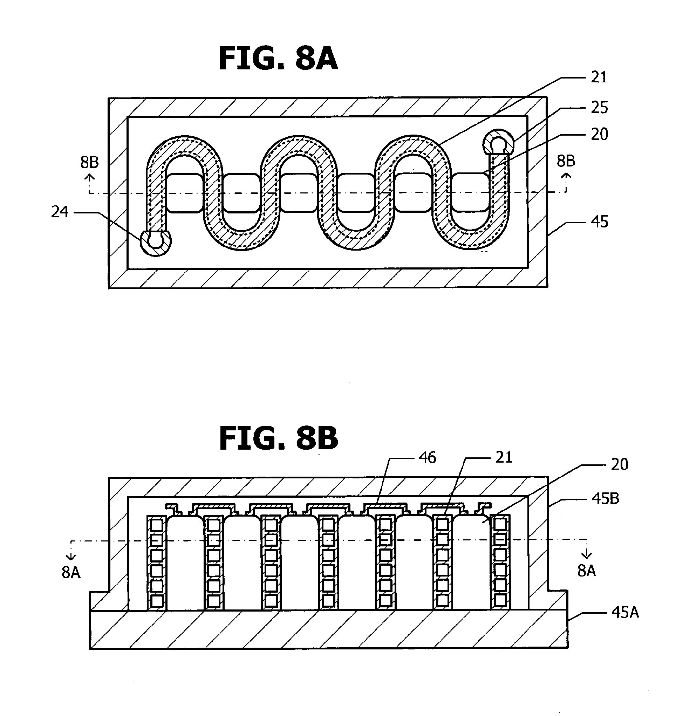

FIG. 8A is a plan cross-sectional view of a power storage module according to Embodiment 2. In descriptions below, the descriptions with respect to the same configuration as Embodiment 1 will be omitted with focusing on the differences from Embodiment 1.

A plurality of power storage cells 20 are arranged in a line. For example, as the power storage cell 20, an electric double layer capacitor is used in which collector electrodes, separators, electrolyte, and the like are accommodated in a case having stiffness. Instead, a lithium ion capacitor, a lithium ion secondary battery, or the like which is accommodated in the case having stiffness may be used.

The heat transmission plate 21 has a plan cross-section of a meandering shape and passes between the power storage cells 20 in an arranged order. The power storage cells 20 and the heat transmission plate 21 are accommodated in a case 45.

FIG. 8B is a cross-sectional view of a dashed-dotted line 8B-8B of FIG. 8A. The case 45 includes a flat plate-shaped bottom plate 45A and an upper cover 45B. Each of the power storage cells 20 is fixed to the bottom plate 45A by a bolt or the like. The heat transmission plate 21 passes between the power storage cells 20. The upper cover 45B covers the power storage cells 20 and the heat transmission plate 21. Wirings 46 connect the plurality of power storage cells 20 in series.

In Embodiment 2, since each of the power storage cells 20 is fixed to the bottom plate 45A, it is not necessary to apply the compressive force for mechanically supporting the power storage cells 20. Moreover, since each of the power storage cells 20 is accommodated in the case having stiffness, it is not necessary to apply the compressive force for maintaining electrical characteristics. Thereby, in Embodiment 2, the pressurization mechanism of Embodiment 1 is not needed. Since the compressive force is not applied to the power storage cells 20 and the heat transmission plate 21, in order to secure improved heat transfer characteristics between the power storage cells 20 and the heat transmission plate 21, it is preferable that heat transfer grease be coated between both or a heat transfer sheet be interposed between both.

It is also possible to effectively cool the power storage cells 20 in Embodiment 2. Moreover, it is possible to suppress the increase of the number of parts for cooling.

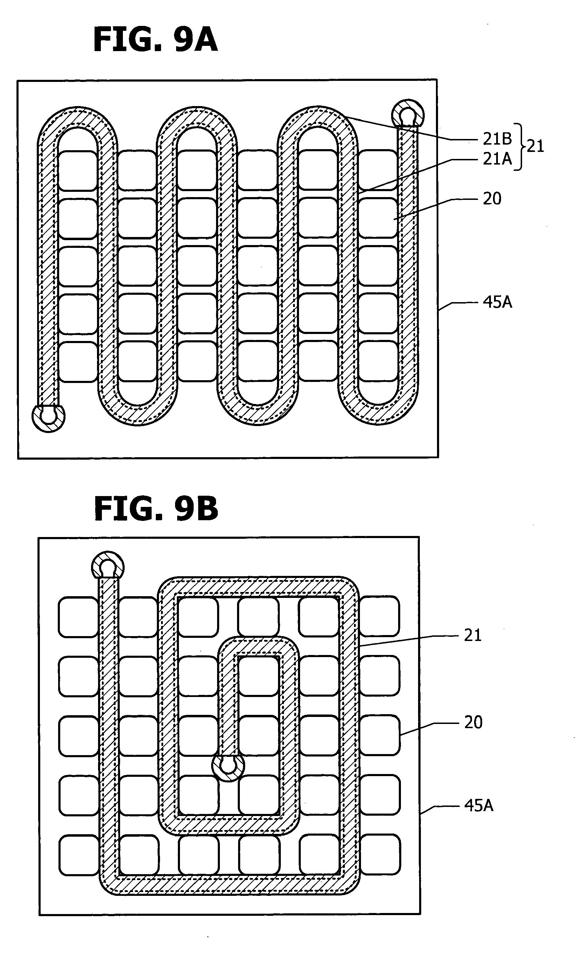

FIG. 9A is a plan cross-sectional view of a power storage module according to Modification 1 of Embodiment 2. In descriptions below, the descriptions with respect to the same configuration as Embodiment 2 will be omitted with focusing on the differences from Embodiment 2 shown in FIGS. 8A and 8B.

In Modification 1, the plurality of power storage cells 20 are arranged in a matrix on the bottom plate 45A. The plan cross-section of the heat transmission plate 21 exhibits a meandering shape similar to the case of Embodiment 1. The heat transmission plate 21 is held on the bottom plate 45A in such posture that the heat absorbing plates 21A are perpendicular to the row direction. Each of the heat absorbing plates 21A is disposed between one column of the power storage cells 20 and a column adjacent to the one column.

FIG. 9B is a plan cross-sectional view of a power storage module according to Modification 2 of Embodiment 2. In descriptions below, the differences from Modification 1 of FIG. 9A will described. In Modification 1, the plan cross-section of the heat transmission plate 21 has a meandering shape. In contrast, in Modification 2, the plan cross-section of the heat transmission plate 21 has a spiral shape. The heat transmission plate 21 passes between the power storage cells 20 in the column direction and the row direction.

It is also possible to effectively cool the power storage cells 20 in Modification 1 and Modification 2 of Embodiment 2. Moreover, it is possible to suppress the increase of the number of parts for cooling.

### [Embodiment 3]

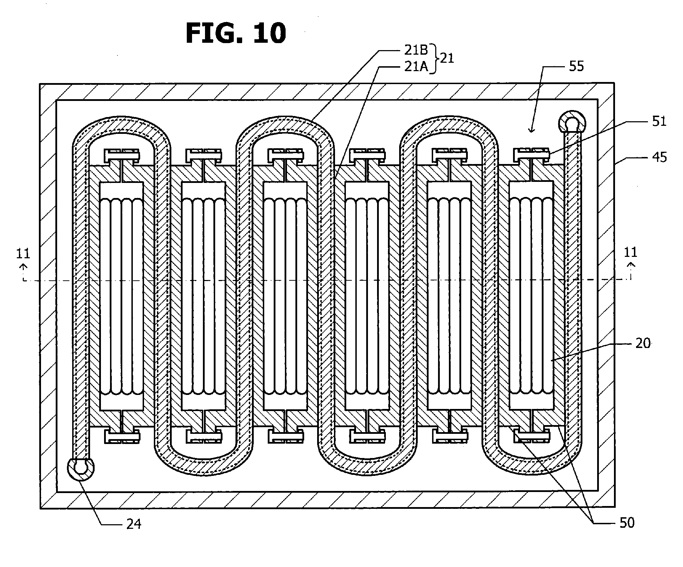

FIG. 10 is a plan cross-sectional view of a power storage module according to Embodiment 3. In descriptions below, the descriptions with respect to the same configuration as Embodiment 1 will be omitted with focusing on the differences from Embodiment 1 shown in FIGS. 1A to 1C.

A plurality of, for example, four power storage cells 20 are interposed by a pair of protection members 50. The pair of protection members 50 is fixed to each other by a fastener 51 such as a bolt and a nut, and applies the compressive force in the stacked direction to the power storage cells 20. The protection members 50 have sufficient stiffness for applying a desired compressive force to the power storage cells 20. One block 55 is comprised of the power storage cells 20 and the pair of protection members 50 which interpose the power storage cells 20.

The plurality of blocks 55 are arranged in a line. Similar to Embodiment 1, the heat transmission plate 21 exhibits a meandering shape, and the heat absorbing plate 21A is disposed between two blocks 55 adjacent to each other. The heat generated in the power storage cell 20 is transmitted to the heat absorbing plate 21A via the protection member 50. The blocks 55 and the heat transmission plate 21 are accommodated in the case 45.

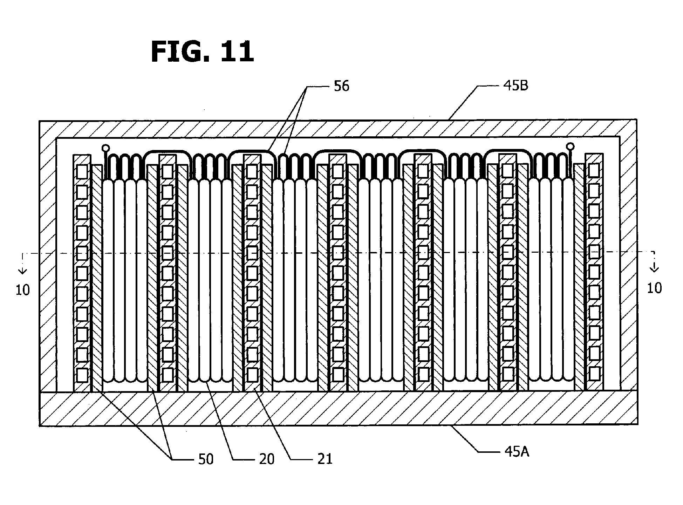

FIG. 11 is a cross-sectional view of a dashed-dotted line 11-11 of FIG. 10. The cross-sectional view of the dashed-dotted line 10-10 of FIG. 11 corresponds to FIG. 10. The case 45 is comprised of the bottom plate 45A and the upper cover 45B. The protection member 50 is fixed to the bottom plate 45A by a fastener such as a bolt. A plurality of power storage cells 20 are connected in series by wirings 56.

In Embodiment 3, since the protection members 50 apply the compressive force to the power storage cells 20 and the protection members 50 are fixed to the bottom plate 45A, the pressurization mechanism comprised of the end plates 31 and 34 and the fastener 37 of Embodiment 1 is not needed.

Next, Modification of Embodiment 3 will be described. In this Modification, as the protection member 50, a protection member which does not have sufficient stiffness for applying a desired compressive force to the power storage cells 20 is used. In this case, the protection members 50 are connected to one another slightly so that the power storage cell 20 does not drop from between the protection members 50. A desired pressure is applied to the power storage cells 20 by the pressurization mechanism which is comprised of the end plates 31 and 34 and the fastener 37 shown in FIG. 1. Since high stiffness is not required in the protection member 50, the weight of the protection member 50 is reduced and the thickness can be thinned. Thereby, the cost can be decreased.

### [Embodiment 4]

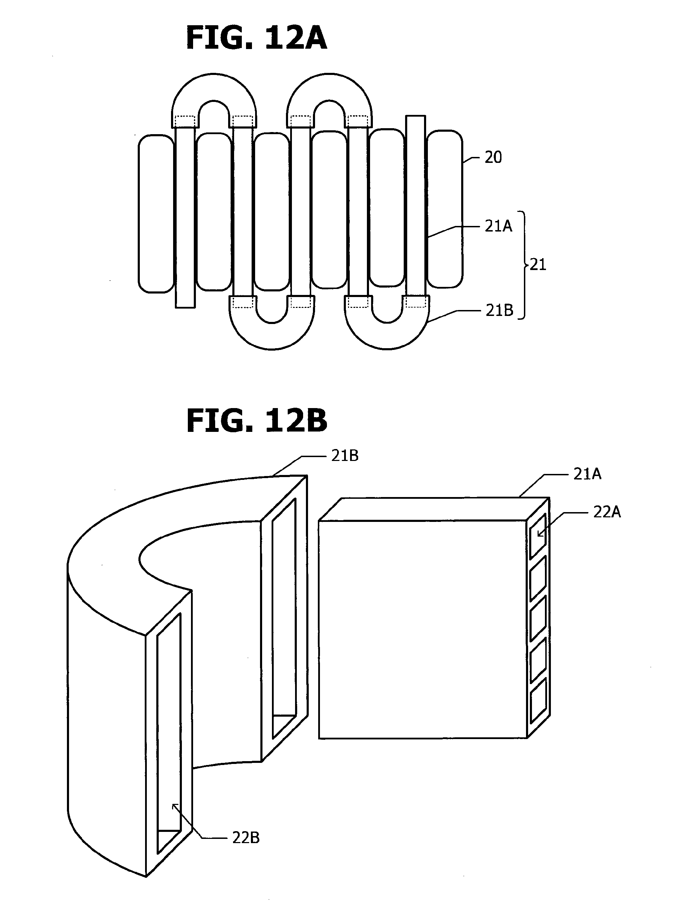

FIG. 12A is a plan view of the heat transmission plate 21 and the power storage cells 20 which are used in a power storage module according to Embodiment 4 and FIG. 12B is an exploded perspective view of the heat transmission plate 21. In descriptions below, the descriptions with respect to the same configuration as Embodiment 1 will be omitted with focusing on the differences from Embodiment 1 shown in FIGS. 1A to 1C. In Embodiment 1, the heat transmission plate 21 having the meandering shape is formed by folding the flat plate-shaped heat transmission plate 21. In Embodiment 4, the flat plate-shaped heat absorbing plates 21A and the bent connection members 21B are formed in a different material.

For example, similar to the heat transmission plate 21 of Embodiment 1, it is preferable that the heat absorbing plates 21A be manufactured by extrusion-molding. The flow channels 22A for cooling medium which extend from one end surface to the opposite end surface is formed in the heat absorbing plate 21A. For example, the connection member 21B is formed of a material having flexibility such as resin or rubber. The flow channels 22B for cooling medium which extend from one end surface to the opposite end surface is also formed in the inner portion of the connection member 21B.

The cross-sectional shape of the opening end of the flow channel 22B matches the outer shape of the end surface of the heat absorbing plate 21A to which the flow channel 22A is opened. The heat absorbing plate 21A is connected to the connection member 21B by inserting the end portion of the heat absorbing plate 21A into the flow channel 22B of the connection member 21B. The connected portion has a watertight structure using an adhesive or the like in order to prevent leakage of the cooling medium.

In Embodiment 1, the connection member 21B is formed by plastically deforming the metal heat transmission plate 21. On the other hand, in Embodiment 4, since the connection member 21B is formed by resin, flexibility of the connection member 21B is high. When the compressive force is applied to the stacked body of the power storage cells 20 and the heat absorbing plates 21A, the connection members 21B are flexibly deformed according to the amount by which the power storage cells 20 is crushed. Thereby, it is possible to decrease the stress which remains in the heat transmission plate 21 after the compression.

### [Embodiment 5]

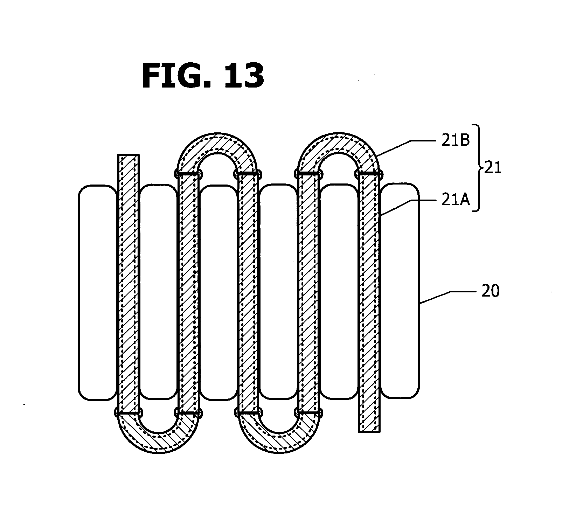

FIG. 13 is a plan cross-sectional view of the heat transmission plate 21 and the power storage cells 20 which are used in a power storage module according to Embodiment 5. In descriptions below, the descriptions with respect to the same configuration as Embodiment 1 will be omitted with focusing on the differences from Embodiment 1 shown in FIGS. 1A to 1C. The heat absorbing plate 21A and the connection member 21B are separately manufactured by extrusion-molding respectively. The connection member 21B is obtained by bending a flat plate-shaped member after the extrusion-molding. The bent flow channel which extends from one end surface to the opposite end surface is formed in the bent connection member 21B. For example, the heat absorbing plate 21A and the connection member 21B are connected by welding or soldering.

Like Embodiment 1, the heat transmission plate 21 having the meandering shape by plastically deforming one flat plate-shaped member has high stiffness. In other words, the spring constant is great. The heat transmission plate 21 of Embodiment 5 is easily deformed, since the stiffness is decreased in the welded location. When the compressive force is applied to the stacked body of the power storage cells 20 and the heat absorbing plates 21A, the heat transmission plate 21 is easily deformed according to the amount by which the power storage cells 20 are crushed. Thereby, it is possible to decrease the stress which remains in the heat transmission plate 21 after the compression.

### [Embodiment 6]

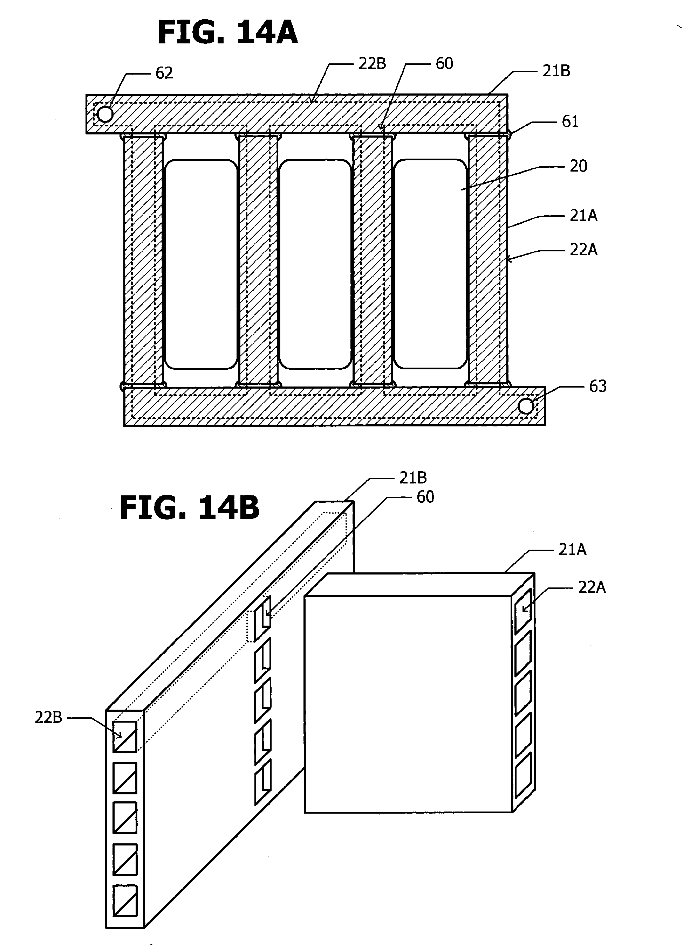

FIG. 14A is a plan cross-sectional view of the heat transmission plate 21 and the power storage cells 20 which are used in a power storage module according to Embodiment 6, and FIG. 14B is an exploded perspective view of the heat transmission plate 21. In descriptions below, the descriptions with respect to the same configuration as Embodiment 1 will be omitted with focusing on the differences from Embodiment 1 shown in FIGS. 1A to 1C.

In Embodiment 1, the connection member 21B is formed by the plate which includes the flow channel and is bent. In contrast, in Embodiment 6, the connection member 21B is formed by a flat plate-shaped plate member. The plurality of flow channels 22B are formed in the connection member 21B. Each of the flow channels 22B extends in the stacked direction of the power storage cells 20.

Openings 60 are formed from the side surface of the connection member 21B to the flow channels 22B in the connection member 21B. If the end surface of the heat absorbing plate 21A contacts the side surface of the connection member 21B on which the openings 60 are formed, the flow channels 22A and the flow channels 22B are connected to each other via the openings 60. The opposite end surface of the heat absorbing plate 21A is connected to the other connection member 21B. For example, the contact portion between the heat absorbing plate 21A and the connection member 21B is formed in a watertight structure by adhesive 61.

Next, the manufacturing process will be described. First, the heat absorbing plates 21A and the power storage cells 20 are stacked, and a compressive force is applied in the stacked direction. In a state where the heat absorbing plates 21A and the power storage cells 20 are compressed, the connection member 21B and the heat absorbing plates 21A are adhered to each other. The openings 60 are disposed in a position which coincides with the opening portions of the flow channels 22A in the heat absorbing plate 21A in the state where the power storage cells 20 and the heat absorbing plates 21A are compressed.

When a compressive force is not required to be applied to the power storage cells 20 as Embodiment 2 shown in FIGS. 8A and 8B and Embodiment 3 shown in FIG. 10, the positions of the openings 60 may be determined based on the positions of the power storage cells 20 (FIGS. 8A and 8B) which is fixed to the bottom plate 45A or the blocks 55 (FIG. 10).

In Embodiment 1, the respective flow channels 22A in the plurality of heat absorbing plates 21A are connected in series. In Embodiment 6, one flow channel 22B is divided into the plurality of flow channels 22A, and thereafter, the divided flow channels 22A are unified to the other flow channel 22B. A cooling medium introduction path 62 is connected to the end portions of the flow channels 22B in one connection member 21B, and a cooling medium discharging path 63 is connected to the opposite end portions of the flow channels 22B in the other connection member 21B.

The cooling medium is introduced from the cooling medium introduction path 62 into the flow channels 22B. The cooling medium which is introduced into the flow channels 22B passes through the flow channels 22A in the heat absorbing plates 21A and the flow channels 22B in the opposite connection member 21B and flows to the cooling medium discharging path 63.

When the flow channels 22A in the heat absorbing plates 21A are connected in series, the cooling performance of the upstream side and the cooling performance of the downstream side may be different from each other. In Embodiment 6, since the flow channels 22A in the heat absorbing plates 21A are connected in parallel, uniform cooling performance can be obtained in the stacked direction of the power storage cells 20 and the heat absorbing plates 21A.

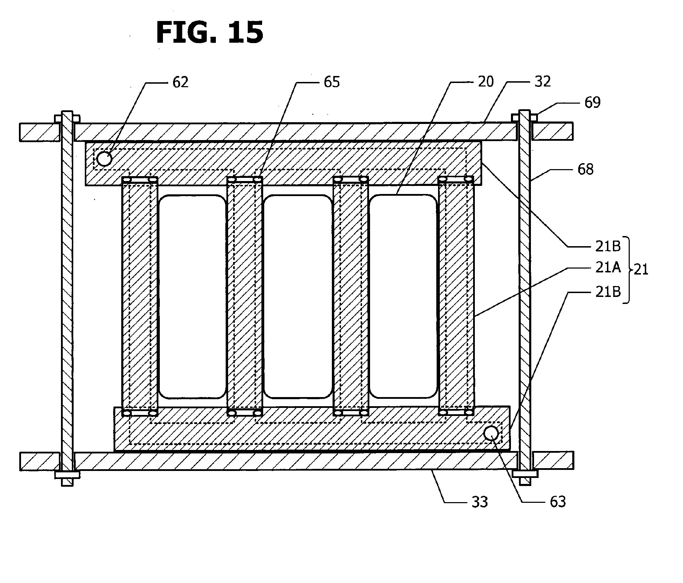

FIG. 15 is a plan cross-sectional view of the heat transmission plate 21 which is used in a power storage module according to Modification of Embodiment 6. In Embodiment 6 shown in FIGS. 14A and 14B, for example, the heat absorbing plates 21A and the connection members 21B are fixed to each other by adhesive or the like, and thus, the watertight structure is obtained. In Modification shown in FIG. 15, O-rings 65 are disposed at the joint locations of the heat absorbing plates 21A and the connection members 21B, and thus, the watertight structure is obtained.

A plurality of tie rods 68 pass through from a side plate 32 which contacts one connection member 21B to a side plate 33 which contacts the other connection member 21B. Nuts are screwed to the end portions of the tie rods 68 and are tightened, and a compressive force is applied to the connection members 21B, the heat absorbing plates 21A, and the O-rings 65 from the side plates 32 and 33. The watertight structure which includes the O-rings 65 is maintained by the compressive force.

In the Modification, since adhesive is not used, the heat transmission plate 21 which is comprised of the heat absorbing plates 21A and the connection members 21B can be easily disassembled.

### [Embodiment 7]

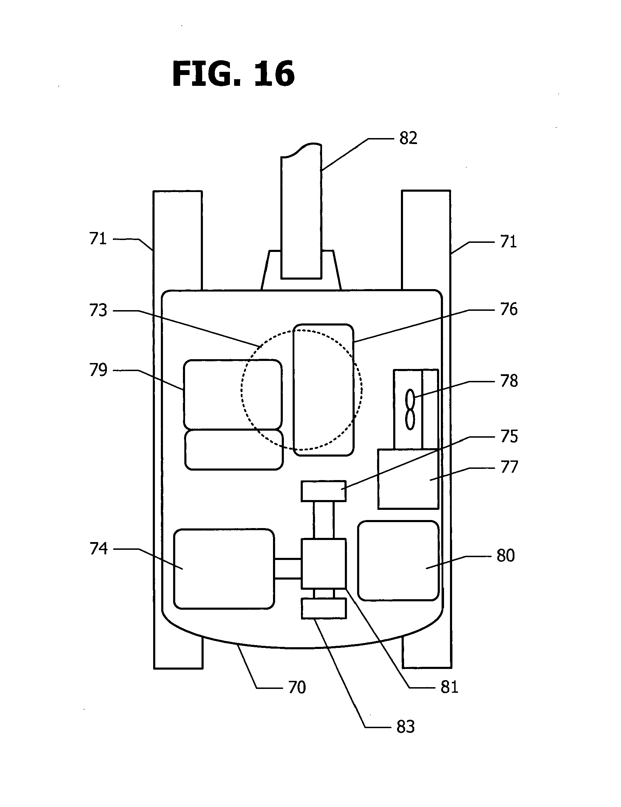

FIG. 16 is a schematic plan view of a shovel which is an example of a hybrid type working machine according to Embodiment 7. A running device 71 is mounted to a rotating body 70 via a rotating bearing 73. An engine 74, a hydraulic pump 75, an electric motor 76, an oil tank 77, a cooling fan 78, a seat 79, a power storage module 80, and a motor generator 83 are mounted on the rotating body 70. The engine 74 generates power by combustion of a fuel. The engine 74, the hydraulic pump 75, and the motor generator 83 send and receive torque to one another via a torque transfer 81. The hydraulic pump 75 supplies pressure oil to a hydraulic cylinder for a boom 82 and so on.

The motor generator 83 is driven by the power of the engine 74 and generates electricity (power generation operation). The generated electric power is supplied to the power storage module 80 and the power storage module 80 is charged. Moreover, the motor generator 83 is driven by the electric power from the power storage module 80 and generates motive power for assisting the engine 74 (assist operation). The oil tank 77 stores oil of a hydraulic circuit. The cooling fan 78 suppresses the increase of the oil temperature of the hydraulic circuit. An operator sits on the seat 79 and operates the hybrid type working machine.

The power storage modules according to Embodiment 1 to Embodiment 6 are used in the power storage module 80. A rotating motor 76 is driven by the electric power which is supplied from the power storage module 80. The rotating motor 76 rotates the rotating body 70. Moreover, the rotating motor 76 generates regenerative electric power by converting kinetic energy to electric energy. The power storage module 80 is charged by the generated regenerative electric power.

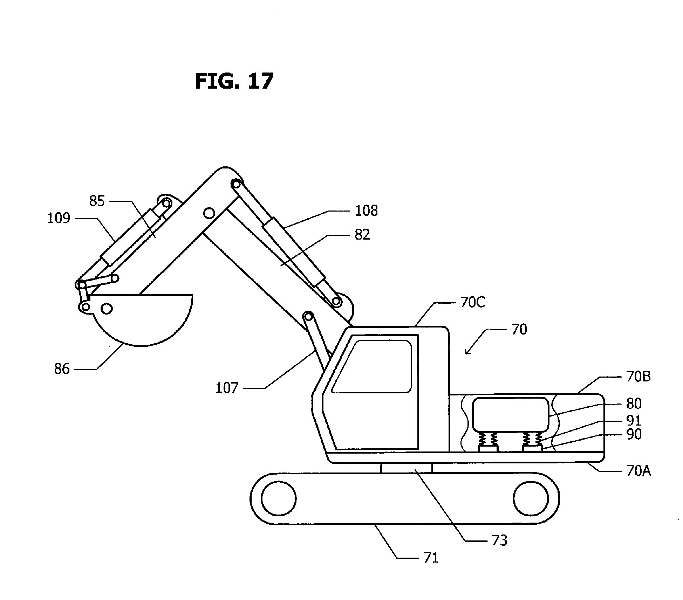

FIG. 17 is a partial breakaway side view of the hybrid type shovel according to Embodiment 7. The upper rotating body 70 is mounted on the lower running body 71 via the rotating bearing 73. The upper rotating body 70 includes a rotating frame 70A, a cover 70B, and a cabin 70C. The rotating frame 70A severs as a supporting structure of the cabin 70C and various parts. The cover 70B covers various parts which are mounted on the supporting structure 70A, for example, the power storage module 80, and the like. The seat 79 (FIG. 16) is accommodated in the cabin 70C.

The electric motor for rotation 76 (FIG. 16) rotates the rotating frame 70A which an object to be driven with respect to the lower running body 71 in a clockwise direction or a counterclockwise direction. The boom 82 is attached to the upper rotating body 70. The boom 82 is vertically swung with respect to the upper rotating body 70 by a boom cylinder 107 which is hydraulically driven. An arm 85 is attached to the tip of the boom 82. The arm 85 is horizontally swung with respect to the boom 82 by an arm cylinder 108 which is hydraulically driven. A bucket 86 is attached to the tip of the arm 85. The bucket 86 is vertically swung with respect to the arm 85 by a bucket cylinder 109 which is hydraulically driven.

The power storage module 80 is mounted on the rotating frame 70A via a mount 90 for power storage module and a damper (vibration-proofing device) 91. For example, the power storage module 80 is disposed in the rear side of the cabin 70C. The cover 70B covers the power storage module 80. Any one of the power storage modules according to Embodiment 1 to Embodiment 7 is used as the power storage module 80. The electric motor for rotation 76 (FIG. 16) is driven by the electric power which is supplied from the power storage module 80. In addition, the electric motor for rotation 76 generates regenerative electric power by converting the kinetic energy to the electric energy. The power storage module 80 is charged by the generated regenerative electric power.

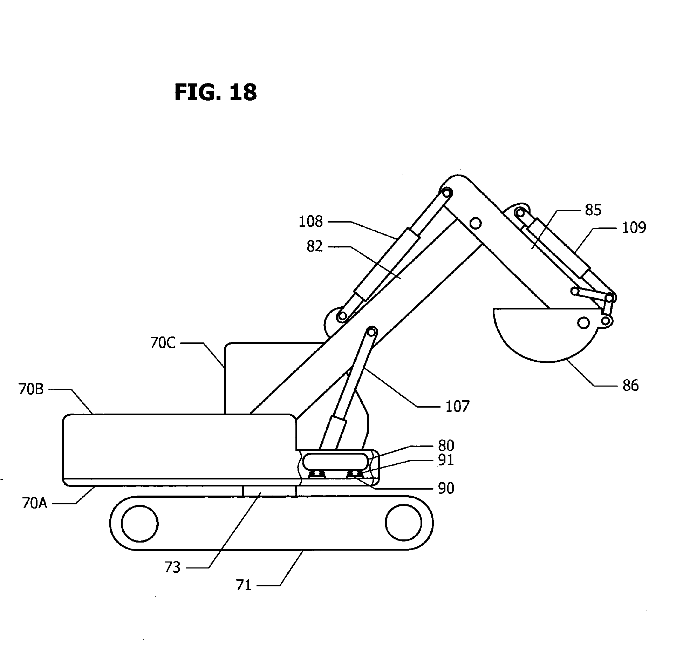

FIG. 18 is a partial breakaway side view of a shovel according to Modification 1 of Embodiment 7. Hereinafter, the descriptions with respect to the same configuration as Embodiment 7 will be omitted while describing with focusing on the differences from the shovel according to Embodiment 7 shown in FIG. 17.

In the example shown in FIG. 17, the power storage module 80 is disposed in the rear side of the cabin 70C. Instead, in the Modification shown in FIG. 18, the power storage module 80 is disposed on the side of the cabin 70C. The boom 82 is attached between the cabin 70C and the power storage module 80. The power storage module 80 is also mounted on the rotating frame 70A and covered by the cover 70B in the Modification.

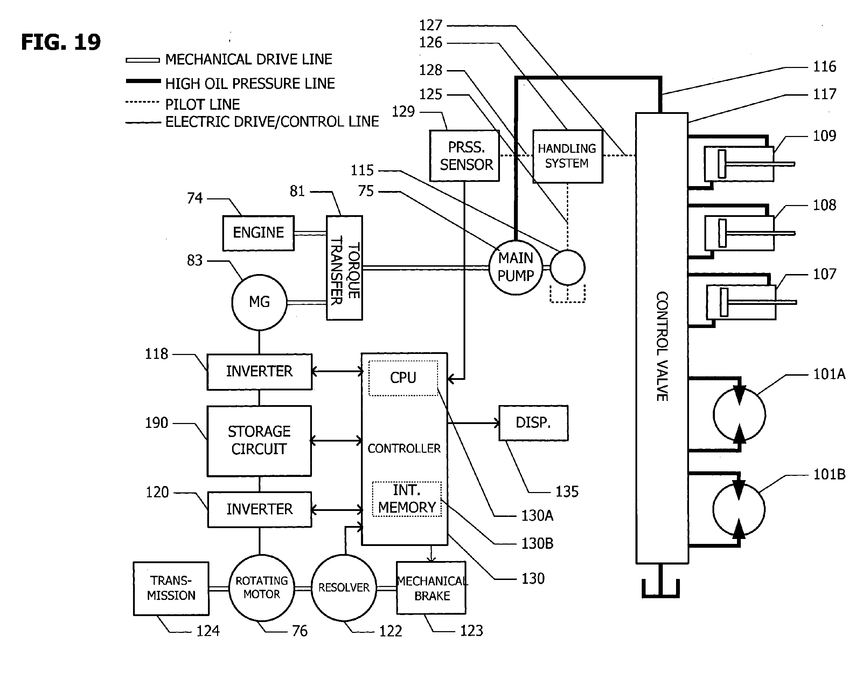

FIG. 19 is a block diagram of the hybrid type shovel according to Embodiment 7. In FIG. 19, a mechanical power system is indicated by a double line, a high oil pressure line is indicated by a thick solid line, an electrical system is indicated by a thin solid line, and a pilot line is indicated by a broken line.

The drive shaft of the engine 74 is connected to the input shaft of the torque transfer 81. As the engine 74, an engine which generates a drive force using a fuel other than electricity, for example, an internal combustion engine such as a diesel engine is used. The engine 74 is always driven during the operation of a working machine.

The drive shaft of the motor generator 83 is connected to the other input shaft of the torque transfer 81. The motor generator 83 can perform both of an electric (assist) operation and a electric power generation operation. For example, as the motor generator 83, Interior Permanent Magnet (IPM) Motor in which a magnet is embedded into the inner portion of a rotor is used.

The torque transfer 81 includes two input shafts and one output shaft. The drive shaft of the main pump 75 is connected to the output shaft.

When load applied to the engine 74 is large, the motor generator 83 performs the assist operation, and the drive force of the motor generator 83 is transmitted to the main pump 75 via the torque transfer 81. Thereby, the load applied to the engine 74 is decreased. On the other hand, when the load applied to the engine 74 is small, the drive force of the engine 74 is transmitted to the motor generator 83 via the torque transfer 81, and thus, the motor generator 83 performs the electric power generation operation. Switching between the assist operation and the electric power generation operation of the motor generator 83 is carried out by an inverter 118 which is connected to the motor generator 83. The inverter 118 is controlled by a controller 130.

The controller 130 includes a central processing unit (CPU) 130A and an internal memory 130B. The CPU 130A carries out a drive control program which is stored in the internal memory 130B. The controller 130 invites an attention of the driver by displaying deterioration states of various devices or the like on the display 135.

The main pump 75 supplies oil pressure to a control valve 117 via a high oil pressure line 116. The control valve 117 distributes the oil pressure to hydraulic motors 101A and 101B, the boom cylinder 107, the arm cylinder 108, and the bucket cylinder 109 according to commands from the driver. Each of the hydraulic motors 101A and 101B drives two left and right crawlers which are provided on the lower running body 71 shown in FIGS. 16 and 17.

The input and output terminals of the electrical system of the motor generator 83 are connected to a power storage circuit 190 via the inverter 118. The inverter 118 performs the operation control of the motor generator 83 based on commands from the controller 130. In addition, the electric motor for rotation 76 is connected to the power storage circuit 190 via other inverter 120. The power storage circuit 190 and the inverter 120 are controlled by the controller 130.

While the motor generator 83 performs the assist operation, the necessary electric power is supplied from the power storage circuit 190 to the motor generator 83. While the motor generator 83 performs the power generation operation, the electric power generated by the motor generator 83 is supplied to the power storage circuit 190.

The electric motor for rotation 76 is driven by alternating current according to the control signals of Pulse Width Modulation (PWM) from the inverter 120 and can perform both of exertion operation and regenerative operation. For example, an IPM motor is used as the electric motor for rotation 76. The IPM motor generates a large induced electromotive force at the time of regeneration.

During the exertion operation of the rotating motor 76, the electric motor for rotation 76 rotates the upper rotating body 70 via a transmission 124. At this time, the transmission 124 decreases the rotational speed. Thereby, the rotation force generated by the electric motor for rotation 76 is increased. Moreover, at the time of a regenerative operation, the rotational movement of the upper rotating body 70 is transmitted to the electric motor for rotation 76 via the transmission 124, and thus, the electric motor for rotation 76 generates the regenerative electric power. At this time, on the contrary to the time of the exertion operation, the transmission 124 increases the rotational speed. Thereby, the rotational speed of the electric motor for rotation 76 can be increased.

A resolver 122 detects the position in the rotation direction of the rotation shaft of the electric motor for rotation 76. The detected results are input to the controller 130. The rotation angle and the rotation direction are derived by detecting the position in the rotation direction of the rotation shaft before and after the operation of the electric motor for rotation 76.

A mechanical brake 123 is connected to the rotation shaft of the electric motor for rotation 76 and generates a mechanical braking force. The braking state and the release state of the mechanical brake 123 are switched by an electromagnetic switch under control of the controller 130.

A pilot pump 115 generates a pilot pressure which is required for an oil pressure handling system. The generated pilot pressure is supplied to a handling system 126 via a pilot line 125. The handling system 126 includes a lever or a pedal and is operated by the driver. The handling system 126 converts the oil pressure of a primary side supplied from the pilot line 125 to the oil pressure of a secondary side upon request of the driver. The oil pressure of the secondary side is transferred to the control valve 117 via an oil pressure line 127 and transferred to a pressure sensor 129 via other oil pressure line 128.

The detected results of the pressure detected by the pressure sensor 129 are input to the controller 130. Thereby, the controller 130 can detect the conditions of the operations of the lower running body 71, the electric motor for rotation 76, the boom 82, the arm 85, and the bucket 86.

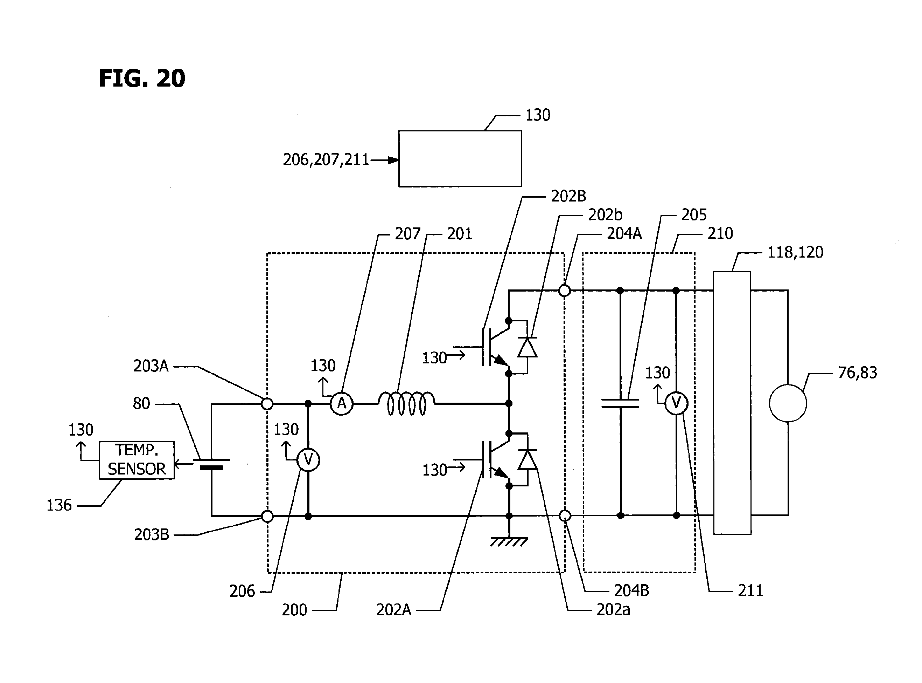

FIG. 20 is an equivalent circuit diagram of the power storage circuit 190. The power storage circuit 190 includes the power storage module 80, a converter 200, and a DC bus line 210. The power storage module 80 is connected to a pair of power source connection terminals 203A and 203B of the converter 200, and the DC bus line 210 is connected to a pair of output terminals 204A and 204B. One power source connection terminal 203B and one output terminal 204B are grounded. Any one of the power storage modules according to Embodiment 1 to Embodiment 7 is used as the power storage module 80.

The DC bus line 210 is connected to the motor generator 83 and the rotating motor 76 via the inverters 118 and 120. The voltage which is generated in the DC bus line 210 is measured by a voltmeter 211, and the measured results are input to the controller 130.

A series circuit in which the collector of a step-up insulated gate bipolar transistor (IGBT) 202A and the emitter of a step-down IGBT 202B are connected to each other is connected between the output terminals 204A and 204B. The emitter of the step-up IGBT 202A is grounded, and the collector of the step-down IGBT 202B is connected to the high voltage side output terminal 204A. The interconnection point of the step-up IGBT 202A and the step-down IGBT 202B is connected to the high voltage side power source connection terminal 203A via a reactor 201.

Diodes 202a and 202b are respectively connected to the step-up IGBT 202A and the step-down IGBT 202B in parallel in a direction in which the direction from the emitter toward the collector is the forward direction. A smoothing capacitor 205 is inserted between the output terminals 204A and 204B.

The voltmeter 206 which is connected between the power source connection terminals 203A and 203B measures the voltage between terminals of the power storage module 80. An ammeter 207 which is inserted into the reactor 201 in series measures charge and discharge current of the power storage module 80. The measured results of the voltage and current are input to the controller 130.

A temperature sensor 136 detects the temperature of the power storage module 80. The detected temperature data is input to the controller 130. For example, the temperature sensor 136 includes four thermometers which are prepared so as to correspond to four power storage cells which are selected from the plurality of power storage cells constituting the power storage module 80. For example, the controller 130 calculates an average of four temperature data which are obtained by four thermometers, and the average value is adopted as the temperature of the power storage module 80. In order to determine an overheat state of the capacitor, the highest temperature among the temperatures indicated by four temperature data may be adopted as the temperature of the power storage module 80. On the other hand, in the determination with respect to a state where the temperature of the power storage module 80 is too low, the lowest temperature among the temperatures indicated by four temperature data may be adopted as the temperature of the power storage module 80.

The controller 130 applies a pulse width modulation (PWM) voltage for control to gate electrodes of the step-up IGBT 202A and the step-down IGBT 202B.

Hereinafter, a step-up operation (discharge operation) will be described. The PWM voltage is applied to the gate electrode of the step-up IGBT 202A. When the step-up IGBT 202A is turned off, an induced electromotive force is generated at the reactor 201 in a direction in which current flows from the power source connection terminal 203A of the high voltage side toward the collector of the step-up IGBT 202A. This electromotive force is applied to the DC bus line 210 via the diode 202b. Thereby, the voltage of the DC bus line 210 is increased.

Next, a step-down operation (charge operation) will be described. The PWM voltage is applied to the gate electrode of the step-down IGBT 202B. When the step-down IGBT 202B is turned off, an induced electromotive force is generated at the reactor 201 in a direction in which current flows from the emitter of the step-down IGBT 202B toward the power source connection terminal 203A of the high voltage side. The power storage module 80 is charged through the diode 202a by the induced electromotive force.

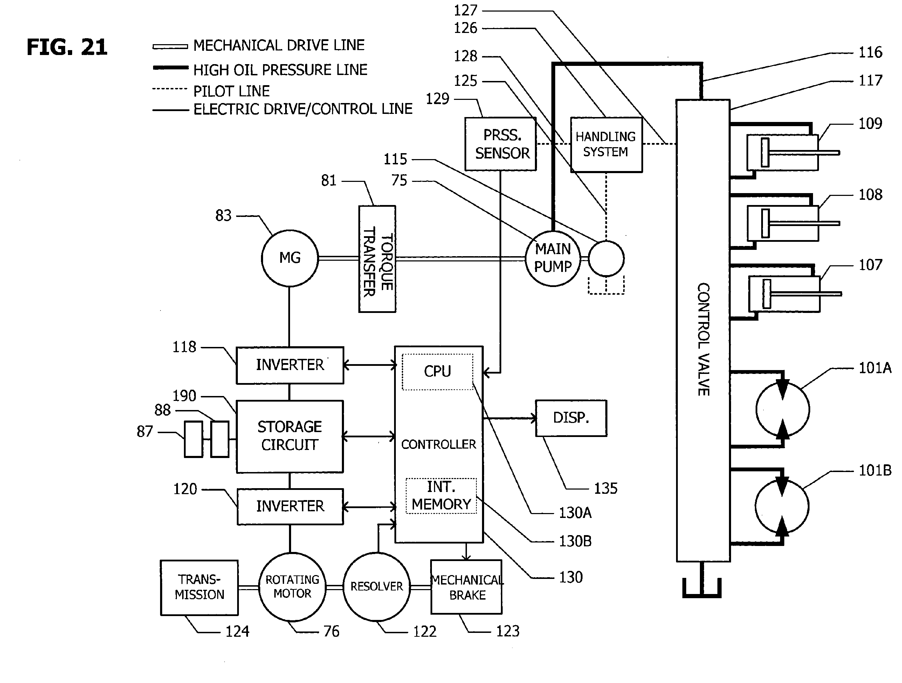

FIG. 21 is a block diagram of a shovel according to Modification 2 of Embodiment 7. Hereinafter, the descriptions with respect to the same configuration as Embodiment 7 will be omitted while describing with focusing on the differences from the hybrid type shovel according to Embodiment 7 shown in FIG. 20.

In the shovel according to Modification 2 of Embodiment 7, the engine 74 (FIGS. 16 and 19) is not mounted. In order to charge the power storage module 80, a voltage converter 88 and an outside power source connection plug 87 are prepared. The power storage module 80 can be charged via the outside power source connection plug 87 and the voltage converter 88 from the outside power source. The motor generator 83 is not operated as a generator and is operated only as an electric motor by the electric power which is supplied from the power storage module 80 (power storage circuit 190).

The voltage converter 88 performs voltage conversion for adapting the voltage of the outside power source to the voltage of the power storage module 80.

The power storage modules according to Embodiment 1 to Embodiment 6 can be applied to not only the hybrid type shovel according to Embodiment 7 but also the electrical shovel as this Modification. Moreover, in Embodiment 7, the shovel is shown as the application example of the hybrid type working machine. However, the power storage modules according to Embodiment 1 to Embodiment 6 may be applied to other construction machines such as a wheel loader or a bulldozer in addition to the shovel.

The present invention is described along the above-described Embodiments. However, the present invention is not limited thereto. For example, a person skilled in the art obviously understands that various modifications, improvement, combinations, or the like can be performed.

Based on the above-described Embodiments, the inventions according to the following appendixes are described.

### (Appendix 1)

There is provided the power storage module including:
a plurality of power storage cells, each of which accumulates electric energy;
a heat absorbing plate which is disposed between the power storage cells and is thermally coupled to the power storage cells and in which a flow channel circulating cooling medium is formed in the inner portion; and
a cooling medium supply device which makes the cooling medium flows into the flow channel formed in the inner portion of the heat absorbing plate.

### (Appendix 2)

In the power storage module according to the Appendix 1,
the heat absorbing plate is disposed in at least two locations so as to be thermally coupled with the power storage cells, and the flow channel which is formed in one heat absorbing plate communicates with the flow channel which is formed in the other heat absorbing plate.

### (Appendix 3)

In the power storage module according to the Appendixes 1 or 2,
the power storage module includes at least three power storage cells which are arranged in a line,
the heat absorbing plate is disposed in a state of being thermally coupled with both of power storage cells in at least two locations between two power storage cells adjacent to each other,
the power storage module further includes a connection member which connects two heat absorbing plate, and
a flow channel, which mutually connects the flow channels formed in the inner portions of two heat absorbing plates, is formed in the inner portion of the connection member.

### (Appendix 4)

In the power storage module according to the Appendix 3,
the heat absorbing plate and the connection member are formed by bending a flat plate-shaped heat transmission plate in which the flow channel is formed in the inner portion, the bent portion of the heat transmission plate corresponds to the connection member, and the flat plate-shaped portion corresponds to the heat absorbing plate.

### (Appendix 5)

In the power storage module according to the Appendix 4,
the power storage module includes at least four power storage cells which are arranged in a line, and
the heat transmission plate includes the heat absorbing plate and the connecting portion, which exhibit a meandering shape as a whole.

### (Appendix 6)

In the power storage module according to the Appendix 5,
the power storage module further includes a pressurization mechanism which applies a force which compresses in the arrangement direction of the power storage cells to the plurality of power storage cells and the heat absorbing plate,
the heat transmission plate is plastically deformed and is formed in a meandering shape, and
the dimension of the heat transmission plate in the arrangement direction in a state where a compressive force is applied by the pressurization mechanism is equal to or longer than a natural length of the heat transmission plate after the plastic deformation.

### (Appendix 7)

In the power storage module according to the Appendix 6,
the power storage module further includes a case which accommodates the power storage cells and the heat transmission plate and includes a bottom plate, a top plate, a pair of side plates, and a pair of end plates which correspond to six virtual planes of a parallelepiped structure, and
the end plates are disposed in both ends in the arrangement direction and fixed to the side plates, and thus, the compressive force is applied to the power storage cells and the heat absorbing plate.

### (Appendix 8)

In the power storage module according to the Appendix 5,
the power storage cells are adhered to the heat absorbing plate by adhesive, and a heat transfer material which increases heat transfer efficiency between the power storage cells and the heat absorbing plate is disposed in an area in which the adhesive is not disposed between the power storage cell and the heat absorbing plate.

### (Appendix 9)

In the power storage module according to the Appendix 8,
the power storage module further includes a case which accommodates the power storage cells and the heat transmission plate and includes a bottom plate, a top plate, a pair of side plates, and a pair of end plates which correspond to six virtual planes of a parallelepiped structure, and
the end plates are disposed at both ends in the arrangement direction and fixed to the side plates.

### (Appendix 10)

In the power storage module according to the Appendix 7,
the heat transmission plate is accommodated in the case with a posture in which a perpendicular projection image to the virtual plane corresponding to the bottom plate exhibits a meandering shape, and
the bottom plate and the top plate fix the heat transmission plate in the case by applying a compressive force in a direction perpendicular to the virtual plane corresponding to the bottom plate to the heat transmission plate.

### (Appendix 11)

In the power storage module according to the Appendix 10,
the power storage module further includes at least two compressive force transmission members which are disposed between the heat transmission plate and the top plate and are long in the arrangement direction,
a compressive force is applied to the heat transmission plate via the compressive force transmission member from the top plate, and
the compressive force transmission member contacts the heat transmission plate in a position further close to the side plate than an edge of the power storage cell facing the side plate.

### (Appendix 12)

In the power storage module according to any one of the Appendixes 4 to 11,
the connection member protrude to further outside in the arrangement direction than at least one position of two heat absorbing plates to which the connection member is connected.

### (Appendix 13)

In the power storage module according to the Appendix 3,
each of the heat absorbing plates is comprised of a flat plate-shaped member which includes a flow channel continuous from one end surface to the opposite end surface in the inner portion,
the connection member is comprised of a member which includes a flow channel extending in the arrangement direction of the power storage cells in the inner portion and an opening continuous to the flow channel is provided on the side of the flow channel, and
the flow channel of the inner portion of the heat absorbing plate is connected to the flow channel of the inner portion of the connection member via the opening.

### (Appendix 14)

In the power storage module according to the Appendix 3,
the power storage module further includes a plurality of protection members, each of which sandwiches at least one power storage cell and applies compressive force in the arrangement direction of the power storage cells, and
the heat absorbing plate is disposed between two protection members adjacent to each other in the arrangement direction.

### (Appendix 15)

There is provided a construction machine including the power storage module according to any one of the Appendixes 1 to 14.

**Reference Signs List**

| | |
|---|---|
| 20: | power storage cell |
| 21: | heat transmission plate |
| 21A: | heat absorbing plate |
| 21B: | connection member |
| 21C: | connection portion |
| 22, 22A, and 22B: | flow channel |
| 24: | cooling medium introduction pipe |
| 25: | cooling medium discharging pipe |
| 26: | cooling medium supply device |
| 31: | end plate |
| 32 and 33: | side plate |
| 34: | end plate |
| 35: | bottom plate |
| 36: | top plate |
| 37: | fastener |
| 38: | wiring |
| 40 and 41: | fastener |
| 45: | case |
| 45A: | bottom plate |
| 45B: | upper cover |
| 46: | wiring |
| 50: | protection member |
| 51: | fastener |
| 55: | block |
| 56: | wiring |
| 60: | opening |
| 61: | adhesive |
| 62: | cooling medium introduction path |
| 63: | cooling medium discharging path |
| 65: | O-ring |
| 68: | tie rod |
| 69: | nut |
| 70: | rotating body |
| 71: | running device |
| 73: | rotating bearing |
| 74: | engine |
| 75: | hydraulic pump |
| 76: | rotating motor |
| 77: | oil tank |
| 78: | cooling fan |
| 79: | seat |
| 80: | power storage module |
| 81: | torque transfer |
| 82: | boom |
| 83: | motor generator |
| 85: | arm |
| 86: | bucket |
| 87: | outside power source connection plug |
| 88: | voltage converter |
| 90: | power storage module mount |
| 91: | damper (vibration-proofing device) |
| 101A and 101B: | hydraulic motor |
| 107: | boom cylinder |
| 108: | arm cylinder |
| 109: | bucket cylinder |
| 114: | main pump |
| 115: | pilot pump |
| 116: | high oil pressure line |
| 117: | control valve |
| 118: | inverter |
| 119: | capacitor |
| 120: | inverter |
| 122: | resolver |
| 123: | mechanical brake |
| 124: | transmission |
| 125: | pilot line |
| 126: | handling system |
| 127 and 128: | oil pressure line |
| 129: | pressure sensor |
| 130: | controller |
| 135: | display |
| 136: | temperature sensor |
| 201: | reactor |
| 202A: | step-up IGBT |
| 202B: | step-down IGBT |
| 202a and 202b: | diode |
| 203A and 203B: | power source connection terminals |
| 204A and 204B: | output terminal |
| 205: | smoothing capacitor |
| 206: | voltmeter |
| 207: | ammeter |
| 211: | voltmeter |

## Claims

1. A shovel, comprising:
a lower running body;
an upper rotating body which is rotatably mounted on the lower running body; and
a power storage module which is mounted on the upper rotating body,
wherein the power storage module comprises:
a plurality of power storage cells, each of which accumulates electric energy;
a heat absorbing plate which is disposed between the power storage cells and is thermally coupled to the power storage cells and has a flow channel formed therein, the flow channel circulating cooling medium; and
a cooling medium supply device which makes the cooling medium flow into the flow channel formed in the heat absorbing plate.

2. The shovel according to claim 1,
wherein the power storage module comprises at least three power storage cells which are arranged in a line,
the heat absorbing plate is disposed in a state of being thermally coupled to both of the power storage cells in at least two locations between two power storage cells adjacent to each other,
the power storage module further comprises a connection member which is connected to two heat absorbing plates, and
a flow channel, which mutually connects the flow channels formed in the inner portions of two heat absorbing plates, is formed in the inner portion of the connection member.

3. The shovel according to claim 1,
wherein the heat absorbing plate is disposed in at least two locations so as to be thermally coupled with the power storage cells, and the flow channel which is formed in one heat absorbing plate communicates with the flow channel which is formed in the other heat absorbing plate.

4. The shovel according to claim 2,
wherein the heat absorbing plate and the connection member are formed by bending a flat plate-shaped heat transmission plate in which the flow channel is formed in the inner portion, a bent portion of the heat transmission plate corresponds to the connection member, and a flat plate-shaped portion corresponds to the heat absorbing plate.

5. The shovel according to claim 4,
wherein the power storage module comprises at least four power storage cells which are arranged in a line, and
the heat transmission plate includes the heat absorbing plate and the connection member, which exhibit a meandering shape as a whole.

6. The shovel according to claim 5, further comprising:
a pressurization mechanism which applies a force which compresses in the arrangement direction of the power storage cells to the plurality of power storage cells and the heat absorbing plate,
wherein the heat transmission plate is plastically deformed and is formed in a meandering shape, and
the dimension of the heat transmission plate in the arrangement direction in a state where a compressive force is applied by the pressurization mechanism is equal to or longer than a natural length of the heat transmission plate after the plastic deformation.

7. The shovel according to claim 6, further comprising:
a case which accommodates the power storage cells and the heat transmission plate and includes a bottom plate, a top plate, a pair of side plates, and a pair of end plates which correspond to six virtual planes of a parallelepiped structure,
wherein the end plates are disposed at both ends in the arrangement direction and fixed to the side plates, and thus, the compressive force is applied to the power storage cells and the heat absorbing plate.

8. The shovel according to claim 5,
wherein the power storage cells are adhered to the heat absorbing plate by adhesive, and a heat transfer material which increases heat transfer efficiency between the power storage cell and the heat absorbing plate is disposed in an area in which the adhesive is not disposed between the power storage cell and the heat absorbing plate.

9. The shovel according to claim 8, further comprising:
a case which accommodates the power storage cells and the heat transmission plate and includes a bottom plate, a top plate, a pair of side plates, and a pair of end plates which correspond to six virtual planes of a parallelepiped structure,
wherein the end plates are disposed at both ends in the arrangement direction and fixed to the side plates.

10. The shovel according to claim 7,
wherein the heat transmission plate is accommodated in the case with a posture in which a perpendicular projection image to the virtual plane corresponding to the bottom plate exhibits a meandering shape, and
the bottom and the top plate fix the heat transmission plate in the case by applying a compressive force in a direction perpendicular to the virtual plane corresponding to the bottom plate to the heat transmission plate.

11. The shovel according to claim 10, further comprising:
at least two compressive force transmission members which are disposed between the heat transmission plate and the top plate and are long in the arrangement direction,
wherein a compressive force is applied to the heat transmission plate via the compressive force transmission member from the top plate, and
the compressive force transmission member contacts the heat transmission plate in a position closer to the side plate than an edge of the power storage cell facing the side plate.

12. The shovel according to claim 4,
wherein the connection member protrudes to further outside in the arrangement direction than at least one position of two heat absorbing plates to which the connection member is connected.

13. The shovel according to claim 2,
wherein each of the heat absorbing plates is comprised of a flat plate-shaped member which includes a flow channel continuous from one end surface to the opposite end surface in the inner portion,
the connection member is comprised of a member which includes a flow channel extending in the arrangement direction of the power storage cells in the inner portion and an opening continuous to the flow channel is provided on the side of the flow channel, and
the flow channel of the inner portion of the heat absorbing plate is connected to the flow channel of the inner portion of the connection member via the opening.

14. The shovel according to claim 2, further comprising:
a plurality of protection members each of which sandwiches at least one power storage cell and applies a compressive force in the arrangement direction of the power storage cells,
wherein the heat absorbing plate is disposed between two protection members adjacent to each other in the arrangement direction.
